# EUROPEAN PATENT APPLICATION

(11) **EP 4 622 087 A1**
(43) Date of publication of application: **24.09.2025**
(21) Application number: 23891118.4
(22) Date of filing: 25.08.2023
(51) Int. Cl.: H02M 7/48, H01L 23/473, H01L 25/07, H01L 25/18

(54) **AGGREGATION MODULE**

(30) Priority: 18.11.2022 JP 2022184923
(71) Applicant: AISIN CORPORATION, Kariya-shi, Aichi 448-8650 (JP)
(72) Inventor: YAMAMOTO, Takeru, Kariya-shi, Aichi 448-8650 (JP); YAMADA, Yasutoshi, Kariya-shi, Aichi 448-8650 (JP); ISHII, Masato, Kariya-shi, Aichi 448-8650 (JP); YAMAGUCHI, Tomohiro, Kariya-shi, Aichi 448-8650 (JP); SASAKI, Sozaburo, Kariya-shi, Aichi 448-8650 (JP)
(74) Representative: Winter, Brandl - Partnerschaft mbB
(86) International application number: PCT/JP2023/030709
(87) International publication number: WO 2024/105958

(57) **Abstract**

An aggregation module includes a plurality of drivers that energize each of a plurality of auxiliary machines mounted on a vehicle, a common substrate equipped with the plurality of drivers, a plurality of busbar bodies that feed power to each of the plurality of drivers, and a module housing holding the substrate and the plurality of busbar bodies, in which each of the plurality of busbar bodies is a primary molded article obtained by integrally molding a plurality of busbars, and the module housing holds each of the plurality of primary molded articles.

## Description

### TECHNICAL FIELD

The present invention relates to an aggregation module including drivers that energize auxiliary machines mounted on a vehicle.

### BACKGROUND ART

Conventionally, various auxiliary machines (an electric pump, a valve device, and the like, for example) are mounted on the vehicle. Such auxiliary machines are energized by a driver. As a technique related to such a driver, for example, there is a technique described in Patent Literature 1 of which source is described below.

Patent Literature 1 describes an inverter device. The inverter device includes a power module including a switching element, a cooling module that cools the power module, a control board including a control circuit that controls the switching element, an AC busbar connected to an AC terminal of the power module, and a current sensor that detects current flowing through the AC busbar.

### CITATIONS LIST

### PATENT LITERATURE

Patent Literature 1: JP 2017-153228 A

### SUMMARY OF INVENTION

### TECHNICAL PROBLEMS

The inverter device described in Patent Literature 1 is downsized by providing on one side of the cooling module the control board equipped with a power module, and by providing the AC busbar and a current sensor on another side of the cooling module. However, as described above, the vehicle includes various auxiliary machines, and if the inverter device is provided for each auxiliary machine, the inverter device is inevitably large in size. For this reason, there is room for improvement in downsizing, in view of correspondence to a plurality of auxiliary machines.

Therefore, an aggregation module capable of being downsized is required.

### SOLUTIONS TO PROBLEMS

A characteristic configuration of an aggregation module according to the present invention is that the aggregation module includes a plurality of drivers that energize each of a plurality of auxiliary machines mounted on a vehicle, a common substrate equipped with a plurality of the drivers, a plurality of busbar bodies that feed power to each of a plurality of the drivers, and a module housing holding the substrate and a plurality of the busbar bodies, in which each of a plurality of the busbar bodies is a primary molded article obtained by integrally molding a plurality of busbars, and the module housing holds each of a plurality of the primary molded articles.

With such a characteristic configuration, the common module housing holds the common substrate equipped with the plurality of drivers and the busbar bodies obtained by integrally molding the busbars that feed power to the plurality of drivers. Therefore, downsizing is possible as compared with, for example, a case where the plurality of drivers are mounted on separate substrates and the busbars are provided separately from the substrates. Therefore, the aggregation module can be reduced in weight. Furthermore, in a case where mounting on a vehicle is considered, flexibility in mounting can be increased, because downsizing is achieved. Moreover, because the primary molded article is produced as a busbar body, it is possible to eliminate complexity of manufacturing the module housing by positioning the individual busbars.

### BRIEF DESCRIPTION OF DRAWINGS

FIG. 1 is a side-sectional view of an aggregation module.
FIG. 2 is a top view of a substrate.
FIG. 3 is a diagram showing an example of a busbar body.
FIG. 4 is a top view of busbar bodies.
FIG. 5 is a diagram showing another example of a busbar body.
FIG. 6 is a diagram showing another example of a busbar body.

### DESCRIPTION OF EMBODIMENTS

An aggregation module according to the present invention is configured such that a plurality of drivers can be mounted on a substrate. Hereinafter, an aggregation module 1 of the present embodiment will be described.

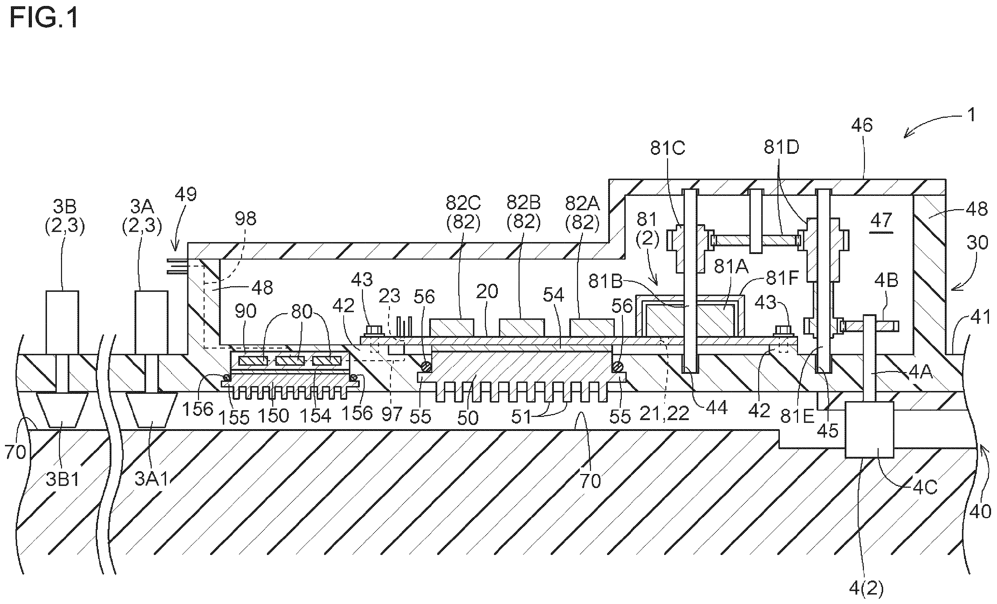

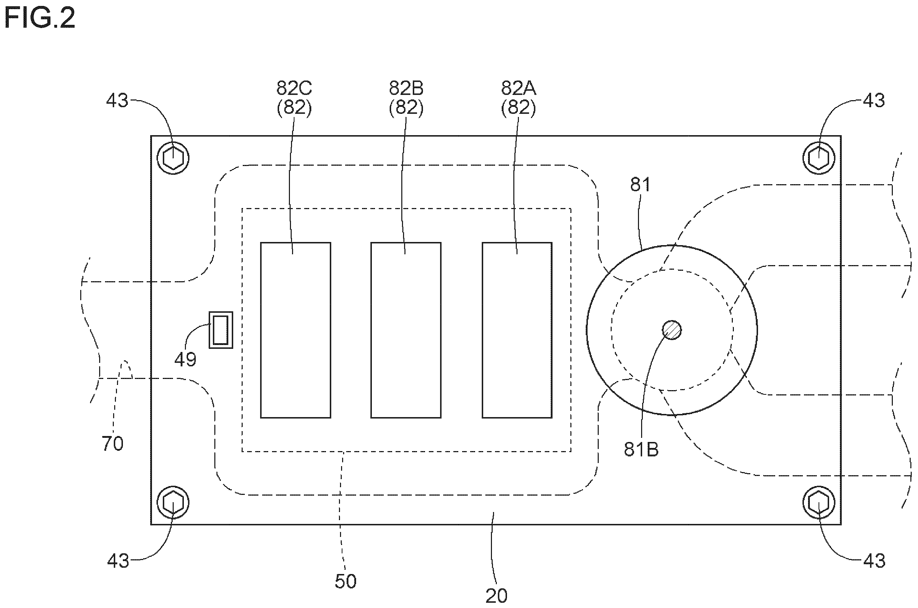

FIG. 1 is a side-sectional view of the aggregation module 1. As shown in FIG. 1, the aggregation module 1 includes drivers 82, a substrate 20, busbar bodies 90, and a module housing 30. FIG. 2 shows a top view of the substrate 20.

A plurality of drivers 82 are provided, and energize each of a plurality of auxiliary machines 2 mounted on a vehicle. The plurality of auxiliary machines 2 mounted on the vehicle are a plurality of apparatuses that assist driving of a power source (an engine or a rotating electrical machine, for example) that moves (drives) a vehicle including the aggregation module 1. Examples of such auxiliary machines 2 include an electric generator, a radiator, an oil pump, a water pump, motors for driving these pumps, a valve device, and the like. Such a plurality of auxiliary machines 2 are mounted on the vehicle, but in the present embodiment, a motor 81, water pumps 3 and a valve device 4 are included as the plurality of auxiliary machines 2. Although details will be described later, in the present embodiment, the motor 81 drives the valve device 4. The motor 81, the water pump 3, and the valve device 4 will be described later.

The drivers 82 energize the motor 81 and the water pump 3. As with an **H-**bridge, a three-phase inverter, or the like, the drivers 82 can include, for example, a plurality of arm portions having a high-side switching element and a low-side switching element that are formed by being connected to each other in series.

An operation command is transmitted from a control unit (not shown) to each of the drivers 82. The operation command includes, for example, a command value of rotational speed, an output torque or the like, and the drivers 82 are controlled on the basis of such a command value. As a result, current having a current value corresponding to the command value flows from the drivers 82 to a coil of the motor 81 that drives the valve device 4 or coils of motors (not shown) included in the water pump 3.

A plurality of drivers 82 are mounted on the substrate 20. **In** the present embodiment, the plurality of drivers 82 are mounted on a common substrate 20. That is, the plurality of drivers 82 are mounted on a single substrate 20. FIG. 1 shows, as the drivers 82, a driver 82A that energizes the motor 81, a driver 82B that energizes the motor of the water pump 3A, and a driver 82C that energizes the motor of the water pump 3B.

In the present embodiment, the substrate 20 is equipped with the motor 81, the driver 82A, the driver 82B, and the driver 82C. The driver 82A, the driver 82B, and the driver 82C include switching elements, and terminals of the switching elements can be fixed by solder welding to lands provided on the substrate 20. Of course, the terminals of the switching elements can be inserted into and fixed to through holes provided in the substrate 20.

Furthermore, the substrate 20 may be equipped with a control unit (not shown) that controls at least one of the plurality of drivers 82. In a case where the motor 81 and the water pump 3 are driven by PWM control, the control unit that controls at least one of the plurality of drivers 82 corresponds to, for example, a PWM control unit. The control unit is not limited to the PWM control unit, and may be, for example, a power feed control unit that is provided at an input stage of the drivers 82 and is able to shut off power supplied to the drivers 82.

Such a substrate 20 includes a rigid substrate from a viewpoint of heat dissipation and load bearing. In particular, the substrate 20 can be implemented at low cost by using a printed circuit board.

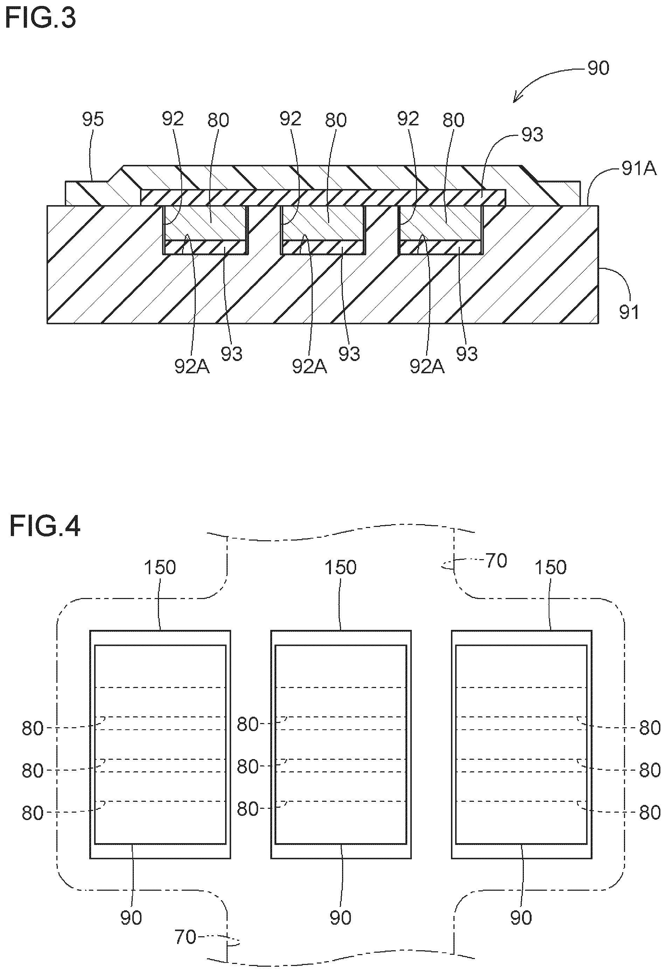

A plurality of busbar bodies 90 (refer to FIG. 4) are provided to feed power to each of the plurality of drivers 82. Each of the busbar bodies 90 includes a plurality of busbars 80. For example, in a case where the drivers 82 include an H-bridge, the busbar bodies 90 include two busbars 80, and in a case where the drivers 82 include a three-phase inverter, the busbar bodies 90 include three busbars 80. In the present embodiment, it is assumed that the busbar bodies 90 have three busbars 80. The busbar bodies 90 having three busbars 80 are provided corresponding to the drivers 82. That is, for example, as in the present embodiment, in a case where the driver 82A, the driver 82B, and the driver 82C constitute the drivers 82, three busbar bodies 90 are provided. Note that, for example, two busbar bodies 90 may be provided for three drivers 82 by sharing two of the three busbar bodies 90 (by one busbar body 90 feeding power to two drivers 82).

Each of the plurality of busbar bodies 90 is configured as a primary molded article obtained by integrally molding the plurality of busbars 80. FIG. 3 is a side-sectional view of a busbar body 90. As shown in FIG. 3, the busbar body 90 includes a main body part 91, busbars 80, holding members 93, and a cover member 95. The main body part 91 is formed in a rectangular parallelepiped shape by using an insulating resin material. One surface (a top surface 91A, for example) of the main body part 91 has groove portions 92 arranged in a predetermined direction. The groove portions 92 are formed according to the number of busbars 80 included in the busbar bodies 90. In the example in FIG. 3, the busbar body 90 has three busbars 80, and thus three groove portions 92 are formed on the main body part 91.

The busbars 80 are housed in the groove portions 92. In the present embodiment, one busbar 80 is housed in one groove portion 92. Therefore, inner dimensions of the groove portion 92 is set to be slightly larger than outer dimensions of the busbar 80. The busbars 80 housed in the groove portions 92 are held by the holding members 93 for positioning in the groove portions 92. In the example in FIG. 3, the holding members 93 are provided on bottom portions 92A of the groove portions 92, and are further provided so as to cover the busbars 80, in a state where the busbars 80 are placed on the holding members 93 provided on the bottom portions 92A. At this time, the holding members 93 are preferably provided to include at least a portion of the top surface 91A of the main body part 91 together with the busbars 80. As a result, the busbars 80 housed in the groove portions 92 can be sandwiched and held from a bottom portion 92A side and top surface 91A side of the groove portions 92. For such holding members 93, for example, insulating thermosetting resin or a foaming adhesive can be used. In this case, by utilizing a heater or induction heating, the thermosetting resin or the foaming adhesive can be overheated to be cured.

The cover member 95 is provided so as to cover the busbars 80 held by the holding members 93, in a state of including at least a portion of the main body part 91. The cover member 95 is preferably made of, for example, insulating resin paste. By curing the resin paste, waterproof and water-resistant properties and mechanical strength of the busbars 80 can be improved. Such busbar bodies 90 are configured as primary molded articles integrally molded with the busbars 80 by, for example, insert molding. In the present embodiment, a plurality of such primary molded articles are configured. Note that, in FIG. 1, the holding members 93 and the cover member 95 are omitted for ease of understanding.

Returning to FIG. 1, the module housing 30 holds the substrate 20 and the busbar bodies 90. The module housing 30 is made of, for example, resin. The module housing 30 has a channel housing 40 to be described later. In the present embodiment, the substrate 20 is held on an outer surface 41 of the channel housing 40. A projection 42 protruding from the outer surface 41 of the channel housing 40 is provided on the outer surface 41, and the substrate 20 is fastened and fixed with bolts 43, in a state of being placed on the projection 42.

Moreover, a plurality of wall portions 48 erected from the outer surface 41 are formed in the channel housing 40, and a top plate 46 is supported over the plurality of wall portions 48. As a result, the substrate 20 is housed in a space 47 surrounded by the channel housing 40, the wall portions 48, and the top plate 46.

Furthermore, the module housing 30 holds each of the plurality of primary molded articles described above. Each of the plurality of primary molded articles may be held by being fastened and fixed to the module housing 30 by using a bolt like the substrate 20, for example, or holes may be formed in the module housing 30 in advance according to outer dimensions of the primary molded articles, and the primary molded articles may be fitted and held in the holes. In the present embodiment, the module housing 30 includes a secondary molded article obtained by integrally molding the plurality of primary molded articles. That is, the module housing 30 is configured by using resin as described above, and at this time, each of the primary molded articles formed in advance by insert molding can be further integrally molded by insert molding to be configured as a secondary molded article. In a case where the module housing 30 is configured as such a secondary molded article, after the module housing 30 is configured as a secondary molded article, the substrate 20 described above is preferably fastened and fixed with the bolts 43 to the module housing 30.

Power is supplied to the busbars 80 included in the busbar bodies 90 and a predetermined land of the substrate 20 via a wiring line 97 and a press-fit 23. Furthermore, in the example in FIG. 1, a wiring line 98 electrically connected to the busbars 80 is provided inside the wall portions 48, and a connector part 49 is formed so as to protrude to a side opposite to the space 47 in the wall portions 48. This makes it possible to extract power from the busbars 80 via the connector part 49.

The motor 81 drives the valve device 4. In the present embodiment, a gear 81C is provided at one end of a rotary shaft 81B of a rotor 81A of the motor 81. A gear 81D that reduces rotational speed of the motor 81 is provided so as to mesh with the gear 81C, and the gear 81D and a gear 4B provided on a rotary shaft 4A of the valve device 4 mesh with each other. This makes it possible for the motor 81 to drive the valve device 4.

Furthermore, the motor 81 is provided such that another end of the rotary shaft 81B penetrates the substrate 20, and the motor 81 is supported by the substrate 20 through a motor housing 81F. The motor housing 81F and the substrate 20 may be fastened and fixed by using, for example, a bolt, or may be fixed by another method. Furthermore, the motor 81 and the substrate 20 can be electrically connected by inserting a press-fit 22 into a through hole 21 provided in the substrate 20.

Furthermore, although the gear 81C is provided at one end of the rotary shaft 81B of the motor 81 as described above, another end of the rotary shaft 81B is supported with bearing, in a state of being inserted into a recess 44 formed in the outer surface 41. Moreover, in the present embodiment, a rotary shaft 81E of the gear 81D is also supported with bearing, in a state of being inserted into a recess 45 formed in the outer surface 41. Therefore, the motor 81 and the gear 81D are held by the module housing 30.

Each of the water pumps 3 cause a coolant to flow through a cooling channel 70. For example, the cooling channel 70 communicates with a device other than a power source such as an engine or a rotating electrical machine and a power source such as an electric generator or a battery, and the coolant discharged from the water pump 3 is supplied through the cooling channel 70. The coolant is cooling water such as a long-life coolant (LLC), an insulating oil such as paraffin, or a refrigerant condensate such as hydrofluorocarbon (HFC) or hydrofluoroolefin (HFO). This makes it possible to cool a supply destination (the engine, the rotating electrical machine, the electric generator, the battery, or the like) of the coolant. In the present embodiment, two water pumps 3 are provided as shown in FIG. 1, and in a case where the water pumps 3 are distinguished from each other, one water pump 3 will be described as a water pump 3A, and another water pump 3 will be described as a water pump 3B.

The valve device 4 is configured to be able to adjust, on the basis of output from the motor 81, an amount of the coolant flowing through the cooling channel 70, or switching channels. As shown in FIG. 1, the valve device 4 is provided on the cooling channel 70. The valve device 4 may be provided to adjust an amount of the coolant sucked into the water pump 3 or switch channels, or may be provided to adjust an amount of the coolant discharged from the water pump 3 or switch the channels. In the present embodiment, the valve device 4 is provided on the cooling channel 70 on which the water pump 3A is provided.

In the present embodiment, the module housing 30 holds the water pump 3A, the water pump 3B, and the valve device 4, in addition to the substrate 20. In the present embodiment, the water pump 3A and the water pump 3B are provided such that a vane part 3A1 and a vane part 3B1 are positioned on a cooling channel 70 side in the module housing 30, and that the valve device 4 is provided such that a valve part 4C is positioned on a cooling channel 70 side in the module housing 30.

The cooling channel 70 described above is formed inside the channel housing 40, and the coolant flows through the cooling channel 70. The channel housing 40 is made of resin, and the cooling channel 70 can be formed, for example, on a split surface by drilling.

The heat sink 50 is provided over the substrate 20 and the cooling channel 70. In the present embodiment, one side of the heat sink 50 is attached to the substrate 20 via a gap filler 54, and another side of the heat sink 50 is provided in a state of being exposed to the cooling channel 70. As shown in FIG. 2, the heat sink 50 is preferably attached to, for example, a back side of an area on the substrate 20, on which the drivers 82 are mounted. Furthermore, at least at a portion where the cooling channel 50 overlaps the heat sink, the cooling channel 70 is preferably wider outward than the heat sink 50 when the substrate 20 is viewed from above. That is, the cooling channel 70 is preferably configured such that the heat sink 50 overlaps the cooling channel 70 when the substrate 20 is viewed from above. As a result, heat from the drivers 82 can be easily transferred to the heat sink 50. Note that a flange portion 55 of the heat sink 50 is preferably provided with a seal member 56 (for example, an O-ring).

**In** the present embodiment, the heat sink 50 is provided in the channel housing 40 and includes fins 51 erected toward an inside of the cooling channel 70. As a result, the heat sink 50 to which the heat from the drivers 82 is transferred can be directly cooled by the coolant flowing through the cooling channel 70. Therefore, the drivers 82 can be cooled more efficiently. The heat sink 50 may be configured such that the fins 51 are erected in a state of intersecting (preferably being orthogonal to) a direction in which the coolant flows through the cooling channel 70, or may be configured such that the fins 51 are erected in a state of being parallel to the direction in which the coolant flows through the cooling channel 70. Furthermore, the heat sink 50 can include a plurality of plate-like members and pins instead of the fins 51.

**In** the present embodiment, the module housing 30 is provided with a heat sink 150 over the busbar bodies 90 and the cooling channel 70. One side of the heat sink 150 is attached to the busbar bodies 90 via a gap filler 154, and another side of the heat sink 150 is provided in a state of being exposed to the cooling channel 70. As shown in FIG. 4, the heat sink 150 is preferably attached to, for example, a back side of areas where the busbars 80 are provided in the busbar bodies 90. Furthermore, at least at the cooling channel 70 preferably overlaps the heat sink 150 when the busbar bodies 90 are viewed from above. That is, the cooling channel 70 is preferably configured such that the heat sink 150 overlaps the cooling channel 70 when the busbar bodies 90 are viewed from above. As a result, heat from the busbars 80 can be easily transferred to the heat sink 150. Note that a flange portion 155 of the heat sink 150 is preferably provided with a seal member 156 (for example, an O-ring).

As described above, by configuring the busbar bodies 90, which include the plurality of busbars 80 electrically connected to the plurality of drivers 82, to be held by the module housing 30, it is possible to configure the aggregation module 1 including the plurality of drivers 82 and plurality of busbars 80 in an aggregated manner. With such an aggregation module 1, downsizing is possible even in a case where the plurality of drivers 82 are provided on the substrate 20. Furthermore, the plurality of drivers 82 can be appropriately cooled.

### [Other embodiments]

In the above embodiment, it has been described that the module housing 30 holds the motor 81, the gear 81D, the valve device 4, and the water pump 3. However, the module housing 30 may hold at least one of the motor 81, the gear 81D, the valve device 4, and the water pump 3. Furthermore, the module housing 30 may not hold the motor 81, the gear 81D, the valve device 4, and the water pump 3.

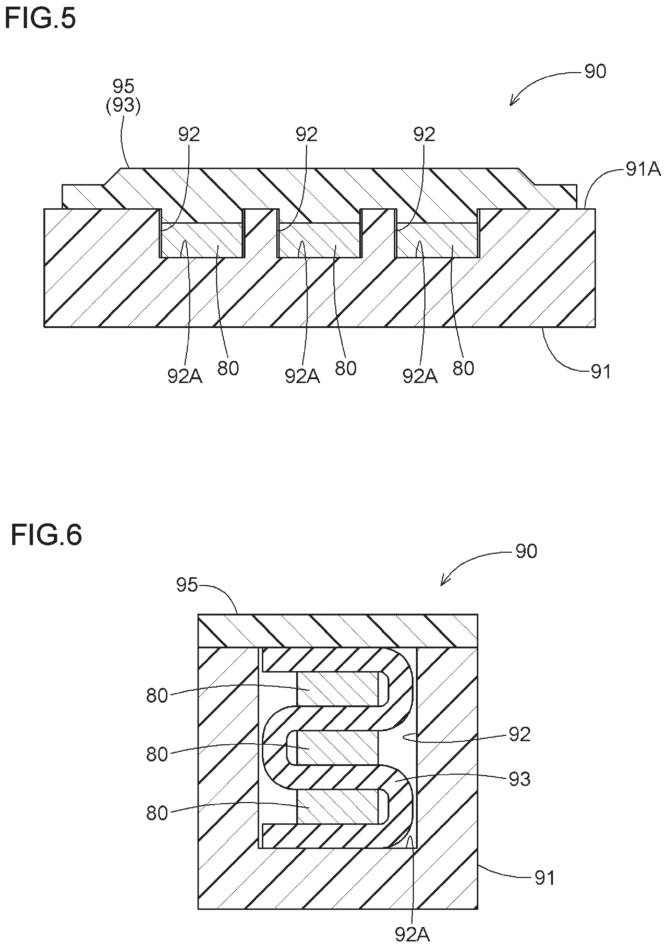

In the above embodiment, it has been described that the busbar bodies 90 include the main body part 91, the busbars 80, the holding members 93, and the cover member 95. For example, the busbar bodies 90 may include the main body part 91, the busbars 80, and either the holding members 93 and the cover member 95. A side-sectional view of such a busbar body 90 is shown in FIG. 5. In this case, the holding member 93 and the cover member 95 are preferably provided in common. That is, either the holding members 93 or the cover member 95 preferably has a holding function of the holding members 93 holding the busbars 80 in the groove portions 92, and a function of the cover member 95 improving the waterproof and water-resistant properties and mechanical strength. Specifically, as shown in FIG. 5, the busbars 80 are preferably housed in the groove portions 92 of the main body part 91, and the cover member 95 (or the holding members 93) is preferably provided to include at least a portion of the top surface 91A of the main body part 91 together with the busbars 80 housed in the groove portions 92. Note that, at this time, the cover member 95 (or the holding members 93) may not be provided or may be provided on the bottom portions 92A of the groove portions 92.

**In** the above embodiment, it has been described that one busbar 80 is housed in one groove portion 92. For example, as shown in FIG. 6, a plurality of busbars 80 may be housed in one groove portion 92. In this case, a holding member 93 is preferably provided on a bottom portion 92A of one groove portion 92 formed in the main body part 91, and the busbars 80 and the holding member 93 are preferably alternately stacked. Furthermore, at this time, by using one sheet-type of holding member 93, the holding member may be provided in a state of being folded as shown in FIG. 6. Of course, the holding members 93 may be provided separately between two busbars 80 adjacent to each other. In any case, a holding member 93 between two busbars 80 adjacent to each other among the plurality of busbars 80 is preferably configured by using an insulating member.

In the above embodiment, it has been described that the substrate 20 is equipped with the control unit that controls at least one of the plurality of drivers 82. However, the substrate 20 may not be equipped with the control unit.

In the above embodiment, it has been described that the substrate 20 is supported by the outer surface 41 of the channel housing 40. However, the substrate 20 may be supported at a portion different from the outer surface 41 of the channel housing 40, or may be supported in a state of being separated from the outer surface 41, for example.

### [Overview of above embodiments]

Hereinafter, an overview of the aggregation module 1 described above will be described.
(1) An aggregation module 1 includes a plurality of drivers 82 that energize each of a plurality of auxiliary machines 2 mounted on a vehicle, a common substrate 20 equipped with the plurality of drivers 82, a plurality of busbar bodies 90 that feed power to each of the plurality of drivers 82, and a module housing 30 holding the substrate 20 and the plurality of busbar bodies 90, in which each of the plurality of busbar bodies 90 is a primary molded article obtained by integrally molding a plurality of busbars 80, and the module housing 30 holds each of the plurality of primary molded articles.
   According to this configuration, the common module housing 30 holds the common substrate 20 equipped with the plurality of drivers 82 and the busbar bodies 90 obtained by integrally molding the busbars 80 that feed power to the plurality of drivers 82. Therefore, downsizing is possible as compared with, for example, a case where the plurality of drivers 82 are mounted on separate substrates 20 and the busbars 80 are provided separately from the substrates 20. Therefore, the aggregation module 1 can be reduced in weight. Furthermore, in a case where mounting on a vehicle is considered, flexibility in mounting can be increased, because downsizing is achieved. Moreover, because the primary molded article is produced as a busbar body 90, it is possible to eliminate complexity of manufacturing the module housing 30 by positioning the individual busbars 80.
(2) In the aggregation module 1 according to (1), the module housing 30 preferably includes a secondary molded article obtained by integrally molding the plurality of primary molded articles.
   According to this configuration, the busbar bodies 90 can be easily held by the module housing 30. Furthermore, because it is only required to form the secondary molded article by molding the primary molded article with resin or the like, positioning of the busbars 80 is easy and molding accuracy is improved. In this manner, the module housing 30 in a state of holding the plurality of busbars 80 can be easily configured.
(3) In the aggregation module 1 according to (1) or (2), each of the busbar bodies 90 preferably includes a main body part 91 having groove portions 92, the busbars 80 housed in the groove portions 92, holding members 93 holding the busbars 80 at the groove portions 92, a cover member 95 that covers the busbars 80 held by the holding members 93, in a state of including at least a portion of the main body part 91.
   According to this configuration, the holding members 93 position and hold each of the plurality of busbars 80 housed in the groove portions 92 of the main body part 91, and the cover member 95 can improve waterproofness and mechanical strength of the busbars 80.
(4) In the aggregation module 1 according to (3), one busbar 80 is preferably housed in one groove portion 92.
   According to this configuration, the module housing 30 is configured to hold the plurality of busbars 80 individually, and thus a short circuit between the plurality of busbars 80 can be prevented. Therefore, a short circuit fault on the drivers 82 can be prevented.
(5) **In** the aggregation module 1 according to (2), the plurality of busbars may be housed in one groove portion 92, and an insulating member may be provided between two busbars 80 adjacent to each other among the plurality of busbars 80.
   According to this configuration, the plurality of busbars 80 can be provided in one groove portion 92 in a stacked manner, and thus, as compared with a case where one busbar 80 is provided in one groove portion 92, the busbar bodies 90 can be reduced in size along a direction (width direction) in which the plurality of busbars 80 are arranged. Therefore, it is possible to improve flexibility in arrangement when the aggregation module 1 is mounted on the vehicle.
(6) In the aggregation module 1 according to (1) or (2), the module housing 30 preferably includes a channel housing 40 in which a cooling channel 70 through which a coolant flows is formed inside.
   According to this configuration, the substrate 20 and the busbars 80 are aggregated by the aggregation module 1, and the cooling channel 70 is further aggregated by the channel housing 40. Therefore, the module housing 30 can be downsized.
(7) In the aggregation module 1 according to (6), the module housing 30 is preferably provided with a heat sink 150 over the busbar bodies 90 and the cooling channel 70.

According to this configuration, because the heat sink 150 is provided over the busbar bodies 90 having the busbars 80 and the cooling channel 70, heat generated in the busbars 80 can be released to the coolant flowing through the cooling channel 70 via the heat sink 150. Therefore, the busbars 80 can be appropriately cooled, and the aggregation module 1 having an excellent cooling effect can be implemented. Furthermore, with a configuration in which heat generated in the drivers 82 is transmitted to the busbars 80, it is also possible to cool the drivers 82 via the busbars 80 and the heat sink 150.

### INDUSTRIAL APPLICABILITY

The present invention can be used for an aggregation module that cools drivers that energize auxiliary machines mounted on a vehicle.

### REFERENCE SIGNS LIST

1: Aggregation module, 2: Auxiliary machine, 20: Substrate, 30: Module housing, 40: Channel housing, 70: Cooling channel, 80: Busbar, 82: Driver, 90: Busbar body, 91: Main body part, 92: Groove portion, 93: Holding member, 95: Cover member, and 150: Heat sink

## Claims

1. An aggregation module comprising:
a plurality of drivers that energize each of a plurality of auxiliary machines mounted on a vehicle;
a common substrate equipped with a plurality of the drivers;
a plurality of busbar bodies that feed power to each of a plurality of the drivers; and
a module housing holding the substrate and a plurality of the busbar bodies, wherein
each of a plurality of the busbar bodies is a primary molded article obtained by integrally molding a plurality of busbars, and
the module housing holds each of a plurality of the primary molded articles.

2. The aggregation module according to claim 1, wherein the module housing includes a secondary molded article obtained by integrally molding a plurality of the primary molded articles.

3. The aggregation module according to claim 1 or 2, wherein each of the busbar bodies includes a main body part having a groove portion, the busbars housed in the groove portion, a holding member holding the busbars at the groove portion, a cover member that covers the busbars held by the holding member, in a state of including at least a portion of the main body part.

4. The aggregation module according to claim 3, wherein one the busbar is housed in one the groove portion.

5. The aggregation module according to claim 3, wherein
a plurality of the busbars are housed in one the groove portion, and
an insulating member is provided between two the busbars adjacent to each other among a plurality of the busbars.

6. The aggregation module according to claim 1 or 2, wherein the module housing includes a channel housing in which a cooling channel through which a coolant flows is formed inside.

7. The aggregation module according to claim 6, wherein the module housing is provided with a heat sink over the busbar bodies and the cooling channel.
